# FASCICULE DE BREVET EUROPEEN

(11) **EP 2 181 434 B1**
(45) Date de publication et mention de la délivrance du brevet: **25.10.2017**
(21) Numéro de dépôt: 08839974.6
(22) Date de dépôt: 01.08.2008
(51) Int. Cl.: G06T 17/00, A61B 6/00, A61B 6/02

(54) **PROCEDE DE RECONSTRUCTION EN TROIS DIMENSIONS D'UN OBJET SINGULIER A PARTIR D'IMAGERIE PAR COUPES (SCANNER, IRM)**
VERFAHREN ZUR DREIDIMENSIONALEN REKONSTRUKTION EINES SINGULÄREN OBJEKTS MITTELS QUERSCHNITTSABBILDUNG (SCANNER, MRT)
METHOD FOR THE THREE-DIMENSIONAL RECONSTRUCTION OF A SINGULAR OBJECT USING CROSS-SECTIONAL IMAGING (SCANNER, MRI)

(30) Priorité: 29.08.2007 FR 0706048
(43) Date de publication de la demande: 05.05.2010
(73) Titulaire: L'école Supérieure Nationale d'Arts et Métiers (ENSAM), 75013 Paris (FR); Centre National de la Recherche Scientifique, 75016 Paris (FR)
(72) Inventeur: JOLIVET, Erwan, F-75011 Paris (FR); SKALLI, Wafa, F-75013 Paris (FR); LAREDO, Jean-Denis, F-75116 Paris (FR); MITTON, David, F-69675 BRON CEDEX (FR)
(74) Mandataire: Robert, Jean-Pierre
(86) Numéro de dépôt international: PCT/FR2008/001148
(87) Numéro de publication internationale: WO 2009/050351

(56) Documents cités:
- WO-A1-2004/114220
- JIANHUA YAO ET AL: "Assessing accuracy factors in deformable 2D/3D medical image registration using a statistical pelvis model" PROCEEDINGS OF THE EIGHT IEEE INTERNATIONAL CONFERENCE ON COMPUTER VISION. (ICCV). NICE, FRANCE, OCT. 13 - 16, 2003; [INTERNATIONAL CONFERENCE ON COMPUTER VISION], LOS ALAMITOS, CA : IEEE COMP. SOC, US, 13 octobre 2003 (2003-10-13), pages 1329-1334VOL.2, XP031213197 ISBN: 978-0-7695-1950-0
- DELORME S ET AL: "THREE-DIMENSIONAL MODELLING AND RENDERING OF THE HUMAN SKELETAL TRUNK FROM 2D RADIOGRAPHIC IMAGES" 3-D DIGITAL IMAGING AND MODELING, 1999. PROCEEDINGS. SECOND INTERNATIO NAL CONFERENCE ON OTTAWA, ONT., CANADA 4-8 OCT. 1999, LOS ALAMITOS, CA, USA,IEEE COMPUT. SOC, US, 4 octobre 1999 (1999-10-04), pages 497-505, XP010358815 ISBN: 978-0-7695-0062-1
- MESSMER P ET AL: "volumetric model determination of the tibia based on 2D radiographs using a 2D/3D database" COMPUTER AIDED SURGERY, TAYLOR & FRANCIS INC., PHILADELPHIA, PA, US, [Online] vol. 6, no. 4, 28 janvier 2001 (2001-01-28), pages 183-194, XP002480615 ISSN: 1092-9088 Extrait de l'Internet: URL:http://www3.interscience.wiley.com/jou rnal> [extrait le 2002-01-28]

## Description

La présente invention concerne un procédé de reconstruction en trois dimensions d'un objet singulier à partir d'une série de relevés en deux dimensions de ce corps.

### ARRIERE PLAN DE L'INVENTION

La connaissance de la géométrie tridimensionnelle d'un corps singulier est utile dans de nombreux domaines et en particulier dans le domaine de la médecine et de la chirurgie.

L'imagerie médicale de type scanner ou IRM permet d'acquérir des données qui sont repérées dans un volume déterminé à partir desquelles il est possible, par des traitements appropriés, d'obtenir des vues radiographiques en deux dimensions d'une structure interne du corps humain.

La reconstitution tridimensionnelle des structures osseuses à partir de ces données demande à l'heure actuelle de pratiquer de nombreuses opérations manuelles car les algorithmes de traitement d'image ne sont pas assez performants. Dans certains cas même, les données initiales ne permettent pas d'aboutir à cette reconstitution car les techniques de traitement d'image (notamment la segmentation) échouent.

On connaît des procédés et des dispositifs qui permettent de procéder, à partir de radiographies multi planaires d'un corps, en association avec une connaissance a priori d'un modèle générique de ce corps et au moyen d'algorithmes de traitement des objets mathématiques que ces radiographies et modèle générique représentent, à la reconstitution en trois dimensions de l'objet radiographié. Cette technique est notamment décrite dans les documents FR 2.810.769 et FR 2.856.170. Cette technique n'est pas adaptée à la reconstruction à partir d'images scanner ou IRM qui sont des techniques d'imagerie fournissant des coupes images d'une certaine épaisseur. Cependant, ces images scanner ou IRM permettent d'obtenir une valeur approchée de certains paramètres descripteurs de la géométrie du corps singulier, valeur qui dans de nombreux cas permet un para-métrage satisfaisant d'un modèle générique.

Le document WO2004/114220 (Brown University)décrit un procédé de reconstruction d'un réseau de canaux pulmonaires à partir d'un modèle tridimensionnel, à base d'éléments cylindriques, et de données d'imagerie médicale du patient. Partant du constat que dans chaque centre d'intervention chirurgicale, notamment en orthopédie, il existe des appareils du type scanner ou d'imagerie IRM, la présente invention entend fournir le moyen de reconstituer la forme en trois dimensions d'un objet, notamment d'un objet osseux, de façon rapide c'est-à-dire en un temps compatible avec la préparation normale d'une intervention chirurgicale de sorte que le résultat de cette reconstitution puisse servir avant l'intervention, comme support ou aide à un diagnostic ou un choix de procédure, soit en cours d'intervention, comme élément de référence introduit par exemple dans un système de navigation.

### OBJET DE L'INVENTION

La présente invention a pour objet un procédé de reconstitution en trois dimensions de la forme d'un corps singulier, dans un repère de référence, à partir de données initiales d'imagerie acquises par un système d'imagerie de type scanner ou de type IRM, caractérisé en ce qu'il comporte les phases suivantes :
- constitution d'un modèle tridimensionnel approché soit sous forme d'une représentation géométrique de sa surface soit sous forme d'un maillage d'éléments finis, du corps singulier à partir d'un modèle générique paramétrable que l'on modifie en fonction de paramètres descripteurs issus desdites données initiales,
- correction du modèle approché par comparaison de ce dernier aux données initiales d'imagerie.

En passant par la reconstitution tridimensionnelle d'un modèle approché du corps singulier, l'invention permet de traiter tous les corps singuliers qui peuvent se présenter, contrairement aux procédés connus. En effet, certains cas ne peuvent pas être traités par la segmentation des images. Dans des procédés utilisant une base de données de corps reconstitués en trois dimensions, certains cas peuvent ne pas être rapprochés d'un quelconque élément de la base. Ainsi, le chirurgien peut-il se trouver dépourvu d'une reconstitution de ce corps singulier, ce qui n'était pas satisfaisant.

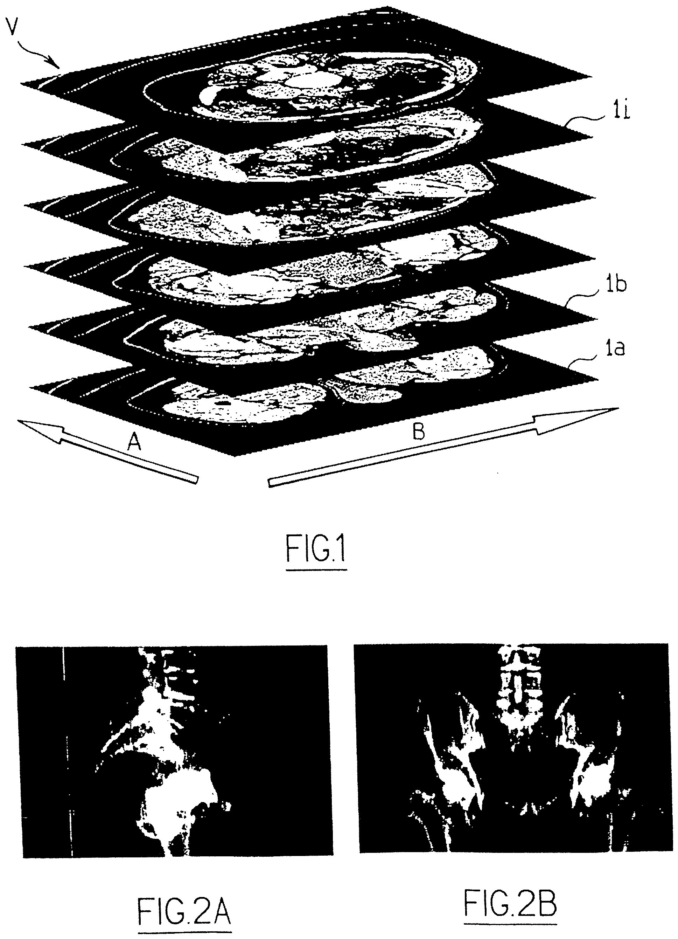

Dans un premier mode de réalisation de l'invention, la phase de constitution du modèle tridimensionnel approché consiste à réaliser deux radiographies simulées du corps (figures 2A et 2B) par projection des données initiales sur deux plans non parallèles mais parallèles à une droite déterminée du repère et à les associer aux moyens d'algorithmes appropriés au modèle générique.

Cette méthode offre l'avantage de présenter les données de l'imagerie sous la forme de deux collections planes de données qui peuvent être traitées comme deux radiographies réalisées selon deux prises de vue non parallèles, avec la rapidité et la fiabilité qui ont aujourd'hui fait leurs preuves dans la stéréoradiographie.

Dans un autre mode de réalisation, la phase de constitution du modèle tridimensionnel approché consiste à appliquer sur le modèle générique paramétrable des valeurs de paramètres descripteurs de la géométrie du corps singulier, directement issues de manière approchée des données initiales.

D'autres caractéristiques et avantages de l'invention ressortiront de la description donnée ci-après d'un exemple de réalisation du procédé de l'invention.

### BREVE DESCRIPTION DES DESSINS

Il sera fait référence aux dessins annexés parmi lesquels :
- la figure 1 illustre par un schéma, différents plans du volume de données obtenu par une imagerie classique de type scanner ou IRM, étagés selon une direction privilégiée (axiale, verticale) du repère de ce volume,
- la figure 2A et 2B sont des schémas de deux radiographies orthogonale simulées par projection des données initiales de l'imagerie selon deux directions perpendiculaires entre elles et perpendiculaires à la direction privilégiée susdite,
- la figure 3 illustre la représentation 3D du corps (bassin) ayant fait l'objet de l'imagerie initiale, obtenu par l'une des méthodes de traitement connues dans le cadre de la stéréoradiographie,
- la figure 4 illustre le relevé sur une image scanner des valeurs de paramètres descripteurs de la géométrie du corps singulier,
- la figure 5 illustre un modèle générique paramétré avec les valeurs relevées à la figure 4,
- les figures 6A, 6B, 6C illustrent la phase finale de reconstruction en trois dimensions du corps ayant fait l'objet de l'imagerie initiale.

### DESCRIPTION DETAILLEE DE L'INVENTION

Les données acquises par imagerie classique telles que le scanner ou l'IRM sont sous une forme représentée à la figure 1. Il s'agit d'un ensemble de données situées de manière repérée dans un volume V déterminé que l'on peut extraire par traitement selon une pluralité de plans la, 1b, ... parallèles de manière à présenter au praticien des image genre tomographie de la zone explorée. Dans le cas de cette description, le corps observé est l'os du bassin.

Les plans la, 1b, ...li ..., sont perpendiculaires à une direction générale du repère du volume qui est verticale et qui correspond à la position du bassin quand le sujet est debout.

Selon l'invention, on traite les données acquises de manière à créer une projection sur un plan parallèle à la direction verticale susdite dans la direction antéro-postérieure (flèche A) du bassin et une seconde projection sur un plan également parallèle à cette direction et dans la direction latérale (flèche B).

Les images résultant de ce traitement sont représentées aux figures 2A (direction antéro-postérieure de la projection) et 2B (direction latérale de la projection). On comprend que de telles projections sont semblables à des radiographies orthogonales du bassin telles qu'on peut les obtenir au moyen des appareils spécialisés de l'état de la technique rappelé au préambule.

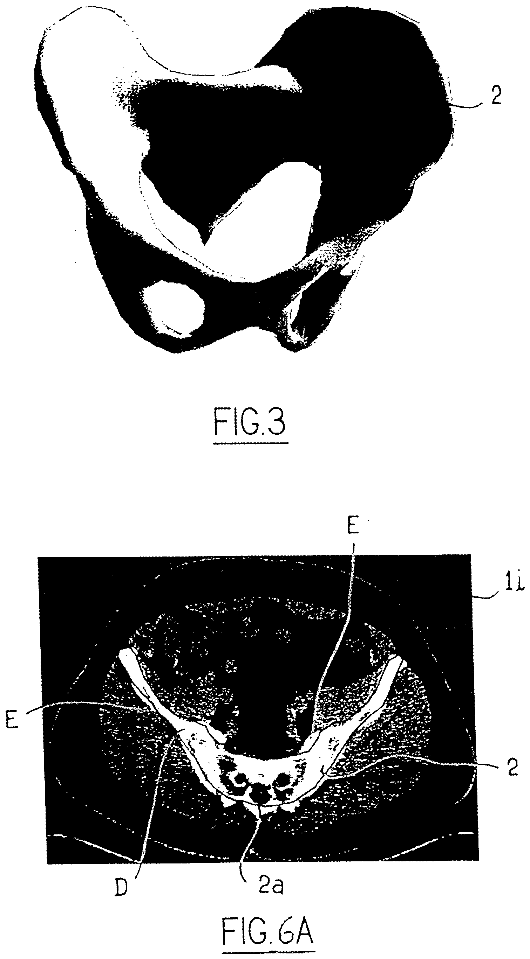

Ces simulations de radiographies permettent avec des algorithmes de traitement appartenant également à l'état de la technique, incluant des modèles génériques ou des banques de données, de procéder à la reconstruction tridimensionnelle d'un premier modèle 2 du bassin tel que représenté à la figure 3. Ce modèle ou modèle initial n'est qu'approché par rapport à la forme réelle du bassin à reconstruire.

Aussi, selon l'invention, on procède à un raffinement du procédé de reconstruction en intégrant cette première reconstruction dans le volume V des données obtenues par l'imagerie classique et en procédant à une correction au moyen d'algorithmes de traitement d'images. Cette première reconstruction joue alors le rôle de modèle générique dans ce traitement, à l'instar de ce qui est connu dans la reconstruction tridimensionnelle de la forme d'un corps par les techniques antérieures.

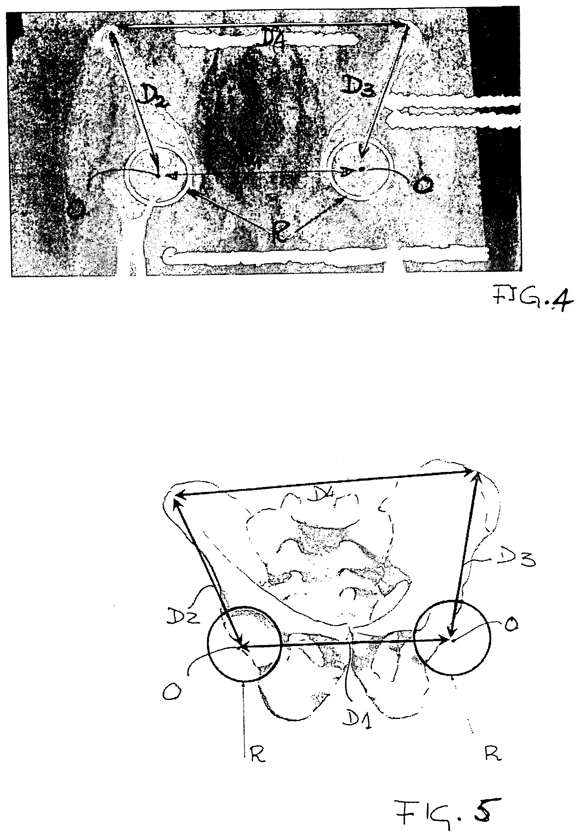

La figure 4 est une image scanner d'un bassin, dans un plan frontal judicieusement choisi pour que l'on puisse déterminer, sur cette image, avec une valeur approchée, relativement proche de la réalité, des paramètres descripteurs du bassin scanné. Ces valeurs seront par exemple le rayon des cupules (acetabulum) d'articulation des têtes de fémur, notés R sur la figure 4, la distance D1 séparant leur centre O, les distances D2 et D3 séparant chaque centre O de chaque crête iliaque et la distance D4 séparant une crête iliaque de l'autre. Les distances D1 à D4 sont approchées car elles sont en réalité les projections dans le plan de la vue de celles-ci.

La figure 5 illustre un modèle générique de bassin dont certains paramètres sont paramétrables. Ce modèle générique paramétrable tridimensionnel est paramétré sous la forme d'un maillage d'éléments finis et sa surface externe est décrite par une méthode connue semblable à celle décrite dans le document FR 2 901 043. Le modèle générique est donc paramétré en fixant, par exemple les valeurs de la position des centres O et des segments R, D1 à D4. On dispose alors d'un modèle initial 2 qui est du type de celui de la figure 3. On peut bien entendu procéder de la même manière en agissant sur une représentation géométrique de sa surface.

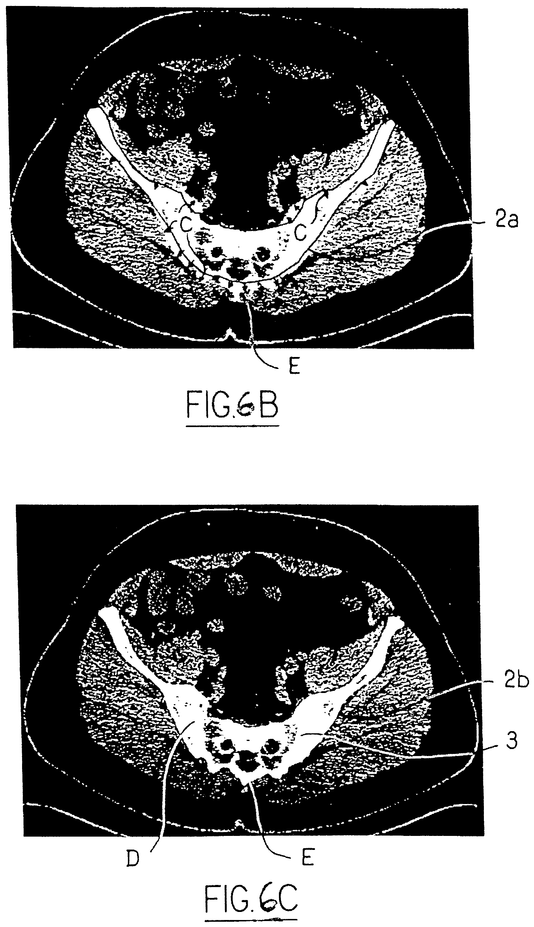

A la figure 6A, on a représenté, dans un plan li tel que la ou 1b, ... la superposition du modèle initial 2 tel que reconstitué et des données D acquises dans le volume V au niveau de ce plan. Les algorithmes employés permettent de déterminer l'enveloppe extérieure de l'os E. En analysant les écarts entre le contour 2a du modèle 2 dans le plan li et l'enveloppe extérieure E dans ce même plan de l'os radiographié, on peut procéder à une déformation de la surface extérieure du modèle initial 2 pour procéder à la finalisation de la personnalisation de la reconstruction. La figure 6B illustre par des flèches C le sens des déformations à réaliser. Cette technique est également connue et fait appel à des points ou contours de contrôle définis entre autres documents dans ceux cités en préambule de la présente description. Cette correction de l'objet ne se fait pas nécessairement dans les plans de coupes, si par exemple le sens des déformations est dans une direction normale à la surface de l'objet reconstruit qui n'appartient pas à ce plan.

Une fois la déformation appliquée, on constate la parfaite adéquation entre le contour 2b du modèle initial déformé 3 et les données acquises par la technique d'imagerie employée. La figure 4C illustre ce résultat

On dispose donc d'une reconstruction du bassin identique à l'os du sujet, numérisée, donc pouvant être traitée de diverses manières pour une utilisation à des fins de diagnostic ou de choix de procédure d'intervention ou pouvant être introduite dans un logiciel de navigation pour assister un praticien dans son intervention.

Le traitement mathématique des différentes données par les algorithmes mentionnés est réalisé par un ordinateur qui possède un périphérique de visualisation du résultat de ce traitement. L'ordinateur est également le siège des mémoires, banques de données et logiciels permettant d'achever les différents calculs dans des délais relativement réduits, en tout cas compatibles avec les phases préparatoires à la réalisation d'une intervention chirurgicale en orthopédie. Le système laisse aussi la possibilité d'une intervention manuelle pour notamment les opérations de raffinement de la forme du modèle.

Bien entendu, l'invention n'est pas limitée au mode de réalisation décrit et on peut y apporter des variantes de réalisation sans sortir du cadre de l'invention tel que défini par les revendications.

En particulier, en variante, la correction peut être réalisée de façon non automatique par un opérateur.

## Revendications

1. Procédé de reconstitution en trois dimensions de la forme d'un corps singulier, dans un repère de référence (V), à partir de données initiales (D) d'imagerie acquises par un système d'imagerie de type scanner ou IRM, **caractérisé en ce qu'**il comporte:
- une phase de modification des paramètres d'un modèle générique paramétrable en fonction de paramètres descripteurs issus des données initiales (D) pour constituer un modèle tridimensionnel approché du corps singulier ;
- une phase de correction du modèle approché en comparant ce modèle approché dernier aux données initiales (D) d'imagerie et en déformant la surface extérieure de ce modèle approché de manière correspondante.

2. Procédé selon la revendication 1, dans lequel la phase de modification des paramètres pour constituer le modèle tridimensionnel approché comporte la réalisation de deux radiographies simulées du corps (figures 2A et 2B) par projection des données initiales sur deux plans non parallèles et l'association de ces deux radiographies simulées au modèle générique, au moyen d'algorithmes appropriés.

3. Procédé selon la revendication 1, **caractérisé en ce que** la phase de modification des paramètres pour constituer le modèle tridimensionnel approché comporte l'application au modèle générique paramétrable des valeurs (R, 0, D1 - D4) de paramètres descripteurs de la géométrie du corps singulier directement issus de manière approchée des données initiales (figures 4 et 5) .

4. Procédé selon la revendication 2 ou 3, dans lequel la correction du modèle approché est réalisée en appliquant des algorithmes de traitement d'image dans lesquels ce modèle approché est utilisé comme un modèle générique (figures 6A, 6B, 6C).

## Patentansprüche

1. Verfahren zur dreidimensionalen Rekonstruktion der Form eines singulären Körpers in einem Bezugssystem (V) anhand von initialen bildgebenden Daten (D), die durch ein bildgebendes System vom Typ Scanner oder MRT erfasst werden, **dadurch gekennzeichnet, dass** es umfasst:
- eine Phase der Modifizierung von Parametern eines parametrierbaren allgemeinen Modells in Abhängigkeit von beschreibenden Parametern, die aus den initialen Daten (D) stammen, um ein angenähertes dreidimensionales Modell des singulären Körpers zu bilden;
- eine Phase der Korrektur des angenäherten Modells, indem dieses angenäherte Modell mit den initialen bildgebenden Daten (D) verglichen und die Außenfläche dieses angenäherten Modells entsprechend umgeformt wird.

2. Verfahren nach Anspruch 1, bei dem die Phase der Modifizierung der Parameter zum Bilden des angenäherten dreidimensionalen Modells die Erzeugung von zwei simulierten Röntgenaufnahmen des Körpers (2A und 2B) durch Projektion der initialen Daten auf zwei nicht parallele Ebenen und die Verknüpfung dieser beiden simulierten Röntgenaufnahmen mit dem allgemeinen Modell mittels geeigneter Algorithmen umfasst.

3. Verfahren nach Anspruch 1, **dadurch gekennzeichnet, dass** die Phase der Modifizierung der Parameter zum Bilden des angenäherten dreidimensionalen Modells die Anwendung an dem parametrierbaren allgemeinen Modell von Werten (R, O, D1 - D4) von Parametern umfasst, die die Geometrie des singulären Körpers beschreiben und direkt auf angenäherte Weise aus den Ausgangsdaten (Figuren 4 und 5) stammen.

4. Verfahren nach Anspruch 2 oder 3, bei dem die Korrektur des angenäherten Modells dadurch erfolgt, dass Bildverarbeitungsalgorithmen angewendet werden, bei denen dieses angenäherte Modell als allgemeines Modell (Figuren 6a, 6B, 6C) verwendet wird.

## Claims

1. A method of three-dimensionally reconstituting the shape of a singular body in a reference coordinate system (V) and on the basis of initial imaging data (D) acquired by an imaging system of the scanner or MRI type, **characterized in that** the method comprises :
• a modification phase of parameters of a parameterizable generic model as a function of descriptive parameters derived from initial data (D) in order to constitute an approximate three-dimensional model of the singular body ;
• a correction phase of the approximate model by comparing the approximate model (2) with the initial imaging data (D), and by deforming the outside surface of the approximate modeling in corresponding manner.

2. The method according to claim 1, wherein the step of constituting the modification phase of parameters to constitute the approximate three-dimensional model comprises the realization of two simulated radiographs of the body (Figures 2A and 2B) by projecting the initial data onto two planes that are not parallel with each other and the association of these two simulated radiographs with the generic model by means of appropriate algorithms.

3. The method of three-dimensional reconstitution according to claim 1, wherein the modification phase of parameters to constitute the approximate three-dimensional model comprises the application of parameter values (R, O, D1-D4) to the parameterizable generic model, which values describe the geometry of the singular body as derived directly in approximate manner from the initial data (Figures 4 and 5).

4. The method according to claim 2 or claim 3, wherein the correction of the approximate model is performed by applying image processing algorithms in which this approximate model is used as a generic model (Figures 6A, 6B, 6C).
